# EUROPÄISCHE PATENTANMELDUNG

(11) **EP 1 855 318 A1**
(43) Veröffentlichungstag der Anmeldung: **14.11.2007**
(21) Anmeldenummer: 07005339.2
(22) Anmeldetag: 15.03.2007
(51) Int. Cl.: H01L 25/07, H01L 23/48, H01L 23/485, H01L 23/051, H01L 23/055

(54) **Kompaktes Leistungshalbleitermodul mit Verbindungseinrichtung**

(30) Priorität: 22.03.2006 DE 102006013078
(71) Anmelder: SEMIKRON Elektronik GmbH & Co. KG, 90431 Nürnberg (DE)
(72) Erfinder: Göbel, Christian, 90441 Nürnberg (DE); Knebel, Markus, 90587 Tuchenbach (DE)

(57) **Zusammenfassung**

Die Erfindung beschreibt ein Leistungshalbleitermodul mit einem Gehäuse, einem Substrat mit Leiterbahnen und hierauf angeordneten Leistungshalbleiterbauelementen und mit einer Verbindungseinrichtung. Diese besteht aus einem Folienverbund aus einer ersten und einer zweiten leitenden jeweils in sich strukturierten und somit Leiterbahnen ausbildenden Schicht und einer dazwischen angeordneten isolierenden Schicht. Die erste leitende Schicht weist erste, als Punktschweißverbindungen ausgebildete Kontakteinrichtungen zu Leistungsanschlussflächen von Leistungshalbleiterbauelementen, zweite Kontakteinrichtungen zu Steueranschlussflächen von Leistungshalbleiterbauelementen, ebenso wie dritte Kontakteinrichtungen zur Lastverbindung mit einer Leiterplatte auf. Die zweite leitende Schicht weist Verbindung zur ersten leitenden Schicht und vierte Kontakteinrichtungen zur Steuerverbindung mit einer Leiterplatte auf. Der Folienverbund weist weiterhin Folienabschnitte zwischen den ersten und zweiten sowie den dritten und vierten Kontakteinrichtungen auf, die in Führungsabschnitten des Gehäuses angeordnet sind.

## Beschreibung

Die Erfindung beschreibt ein kompaktes Leistungshalbleitermodul mit einer Verbindungseinrichtung zur elektrischen Verbindung der Last- und Steueranschlüsse von Leistungshalbleiterbauelementen mit einer externen Leiterplatte. Hierbei soll im Folgenden mit dem Begriff der Lastverbindung eine Verbindung zwischen einer Kontakteinrichtung des Leistungshalbleitermoduls und einem externen Leitungselement verstanden werden, wobei hiermit die Lastanschlüsse, also beispielhaft in einer Halbbrückenschaltung die Gleichstromeingänge vom Zwischenkreis sowie der Wechselstromausgang, verstanden werden.

Analog wird mit Steuerverbindung im Folgenden die Verbindung eines Hilfs- bzw. Steueranschlusses des Leistungshalbleitermoduls mit einem externen Steueranschlusselements verstanden.

Einen Ausgangspunkt der Erfindung bilden Leistungshalbleitermodule, wie sie beispielhaft aus der DE 10 2004 0255 609 A1, oder der DE 103 55 925 A1bekannt sind. Erstgenannte Druckschrift offenbart ein Leistungshalbleitermodul in Schraub-Druckkontaktierung. Die Lastverbindung des Leistungshalbleitermoduls mit einer Leiterplatte wird hierbei mittels eine Schraubverbindung nach dem Stand der Technik erreicht. Die Steuerverbindungen der Hilfs- bzw. Steueranschlüsse sind hierbei ausgebildet als Verbindung zwischen einem Federkontaktelemente und einem Leiterbahnabschnitt der Leiterplatte. Erfindungsgemäß erfolgt die Druckeinleitung auf die Steuerverbindung durch die Anordnung und Verschraubung der Leiterplatte mit den Lastanschlusselementen. Die Ausgestaltung eines Leistungshalbleitermoduls in der genannten Art ist besonders geeignet für Strombelastungen jenseits von 10 Ampere.

Die DE 103 55 925 A1 offenbart eine Verbindungseinrichtung für Leistungshalbleiterbauelemente bestehend aus einem Folienverbund einer ersten und einer zweiten leitenden Folie mit einer isolierenden Zwischenlage. Die Leistungshalbleiterbauelemente sind mit der ersten leitenden Schicht mittels Ultraschallschweißen dauerhaft sicher elektrisch verbunden. Die modulinterne schaltungsgerechte Verbindung der Leistungshalbleiterbauelement, die sowohl Last- als auch Steueranschlüsse beinhaltet ist hier offen gelegt. Allerdings offenbart die genannte Druckschrift keine Details der Last- und Steuerverbindungen zur externen Anbindung.

Der Erfindung liegt die Aufgabe zugrunde ein Leistungshalbleiter mit einer Verbindungseinrichtung in Ausgestaltung eines Folienverbunds vorzustellen, wobei dieses einfach herzustellen ist, kompakte Abmessungen aufweist und sowohl die Lastwie auch die Steueranschlüsse auf einer Leiterplatte anordenbar sind.

Die Aufgabe wird erfindungsgemäß gelöst, durch die Maßnahmen der Merkmale des Anspruchs 1. Bevorzugte Ausführungsformen sind in den Unteransprüchen beschrieben.

Der erfinderische Gedanke geht aus von einem Leistungshalbleitermodul mit einem Gehäuse, mindestens einem Substrat mit Leiterbahnen und auf diesen Leiterbahnen schaltungsgerecht angeordneten Leistungshalbleiterbauelementen. Weiterhin weist das Leistungshalbleitermodul mindestens eine Verbindungseinrichtung auf, wobei diese jeweils aus einem Folienverbund aus einer ersten (60) und einer zweiten (64) leitenden Schicht mit einer zwischen diesen leitenden Schichten angeordneten isolierenden Schicht besteht.

Die jeweiligen leitenden Schichten sind in sich strukturierten und bildenden somit Leiterbahnen aus. Es ist bevorzugt, wenn einzelne Leiterbahnen der beiden leitenden Schichten mittels schaltungsgerechte Verbindung, beispielhaft in Form von Durchkontaktierungen, miteinander verbunden sind.

Die erste leitende Schicht des Folienverbunds weist erste, als Punktschweißverbindungen ausgebildete Kontakteinrichtungen zu Leistungsanschlussflächen von Leistungshalbleiterbauelementen auf. Ebenso weist diese erste leitende Schicht vorzugsweise auf einer weiteren Leiterbahn zweite Kontakteinrichtungen zu Steueranschlussflächen von Leistungshalbleiterbauelementen auf. Weiterhin weist diese erste leitende Schicht dritte Kontakteinrichtungen zur Lastverbindung mit einer Leiterplatte auf. Die zweite leitende Schicht weist vierte Kontakteinrichtungen zur Steuerverbindung mit der Leiterplatte auf.
Der Folienverbund weist Folienabschnitte zwischen den ersten und zweiten, sowie den dritten und vierten Kontakteinrichtungen auf, die in Führungsabschnitten des Gehäuses angeordnet sind, wobei die dritten und vierten Kontakteinrichtungen parallele Flächennormalen aufweisen.

Die erfinderische Lösung wird an Hand der Ausführungsbeispiele der Fig. 1 bis 4 weiter erläutert.

Fig. 1 zeigt eine erste Ausgestaltung eines erfindungsgemäßen Leistungshalbleitermoduls im Schnitt.

Fig. 2 zeigt eine erste Ausgestaltung eines erfindungsgemäßen Leistungshalbleitermoduls in dreidimensionaler Ansicht.

Fig. 3 zeigt eine zweite Ausgestaltung eines erfindungsgemäßen Leistungshalbleitermoduls im Schnitt.

Fig. 4 zeigt den Folienverbund der zweiten Ausgestaltung eines erfindungsgemäßen Leistungshalbleitermoduls.

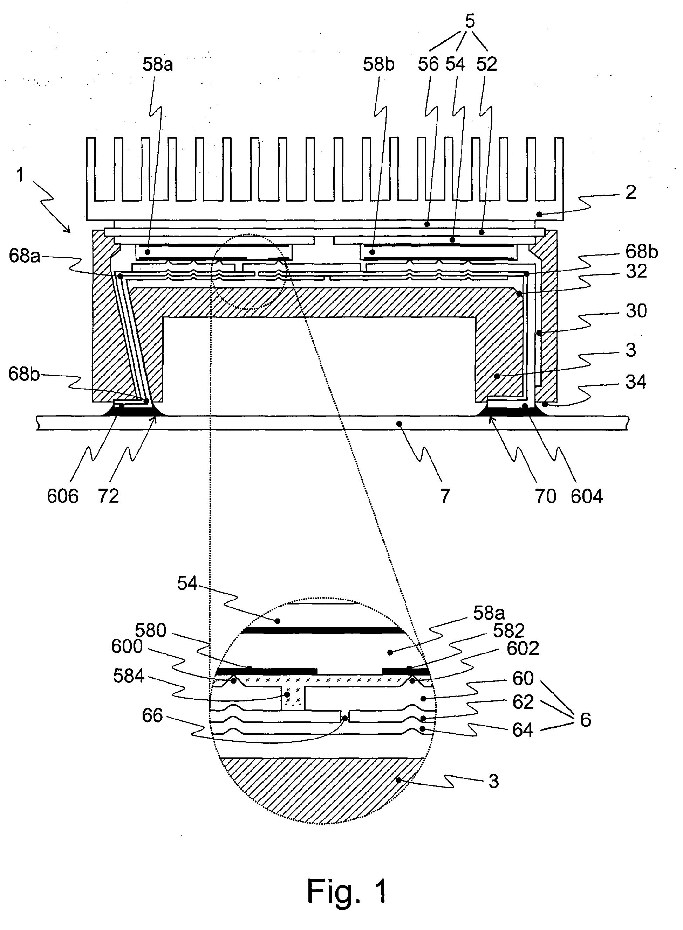

Fig. 1 zeigt eine erste Ausgestaltung eines erfindungsgemäßen Leistungshalbleitermoduls im Schnitt in einer Anordnung mit einem Kühlkörper und einer Leiterplatte. Das Leistungshalbleitermodul besteht aus einem Gehäuse (3), welches ein Substrat (5) derart umschließt, dass dieses die dem Inneren des Leistungshalbleitermoduls abgewandte Seite des Gehäuses teilweise überragt. Auf diese Seite des elektrisch isolierend ausgebildeten Substrats ist der der Kühlkörper angeordnet und thermisch leitend mit dem Substrat verbunden.

Die dem Inneren des Leistungshalbleitermoduls zugewandte Seite des Substrats ist als eine Mehrzahl von voneinander elektrisch isolierten Leiterbahnen (54) ausgebildet. Auf diesen Leiterbahnen ist eine Mehrzahl von Leistungshalbleiterbauelementen (58 a/b) schaltungsgerecht angeordnet und elektrisch leitend verbunden.

Weiterhin weist das Leistungshalbleitermodul eine Verbindungseinrichtung (6) auf, die aus einem Folienverbund besteht. Dieser Folienverbund wird gebildet aus einer ersten (60) und einer zweiten (64) leitenden jeweils in sich strukturierten und somit Leiterbahnen ausbildenden Schichten und einer dazwischen angeordneten isolierenden Schicht (62),

Die erste leitende Schicht (60) diese Folienverbunds weist erste, als Punktschweißverbindungen ausgebildete Kontakteinrichtungen (600) zu Leistungsanschlussflächen (580) von Leistungshalbleiterbauelementen (58 a/b) auf. Ebenso weist sie zweite Kontakteinrichtungen (582) zu Steueranschlussflächen (582) der Leistungshalbleiterbauelementen (58a) auf. Somit bildet die erste leitende Schicht bzw. deren Leiterbahnen mit den Kontakteinrichtungen die schaltungsgerechte Verbindung der dem Substrat abgewandten Anschlussflächen der Leistungshalbleiterbauelementen (58 a/b). Das Volumen zwischen dem Substrat (5) mit den Leistungshalbleiterbauelementen (58) und der ersten leitenden Schicht (60) ist aus Gründen der elektrischen Sicherheit mit einem isolierenden Stoffes verfüllt, wobei dieser isolierende Stoff vorzugsweise ein Silikongel oder ein Epoxidharz (584) ist.

Die erste leitende Schicht weist weiterhin dritte Kontakteinrichtungen (604) zur Lastverbindung (70) mit einer Leiterplatte (7) auf. Diese dritten Kontakteinrichtungen sind mit ersten Kontakteinrichtungen und somit mit den Lastanschlussflächen des zugeordneten Leistungshalbleiterbauelements elektrisch leitend verbunden.

Die zweite leitende Schicht (64) weist schaltungsgerechte Verbindung (66) zur ersten leitenden Schicht (60) auf um beispielhaft die Steueranschlussflächen (582) der Leistungshalbleiterbauelemente (58a) mit vierten Kontakteinrichtungen (606) zur Steuerverbindung (72) mit einer Leiterplatte (7) zu verbinden.

Es ist bevorzugt, wenn dritte und vierte Kontakteinrichtungen jeweils in einer Reihe angeordnet sind. Hierzu weist das Leistungshalbleitermodul Führungsabschnitte (30) innerhalb des Gehäuses (30) auf, in dem Folienabschnitte des Folienverbunds angeordnet sind. Diese Folienabschnitte bilden die Verbindung zwischen den ersten und zweiten (600, 602) sowie den dritten und vierten (604, 606) Kontakteinrichtungen.

Um die genannte Ausgestaltung des Leistungshalbleitermoduls zu bilden weist der Folienabschnitt zu dritten Kontakteinrichtungen (604) eine erste und eine zweite Biegestelle (68b) mit gleicher Biegerichtung auf. Der Folienabschnitt zu vierten Kontakteinrichtungen (606) weist demgegenüber eine erste Biegestelle (68a) mit einer ersten Biegerichtung und im weiteren Verlauf eine zweite Biegestelle (68b) mit entgegen gesetzter zweiter Biegerichtung auf. Hierbei sind die Biegestellen (68 a/b) an zugeordneten Kanten (32) der Führungsabschnitte (30) des Gehäuses (3) angeordnet.

Durch diese Ausgestaltung sind sowohl die dritte wie auch die vierte Kontakteinrichtungen in einer durch die zu kontaktierende Leiterplatte bestimmten Ebene angeordnet. Gleichfalls bilden somit die Kontakteinrichtungen Flächen mit parallelen Flächennormalen. Das Gehäuse ist derart ausgebildet, dass die dritten (604) und vierten (606) Kontakteinrichtungen das Gehäuse (3) in Richtung ihrer Flächennormalen überragen und somit eine Lötverbindung zur Leiterplatte möglich ist.

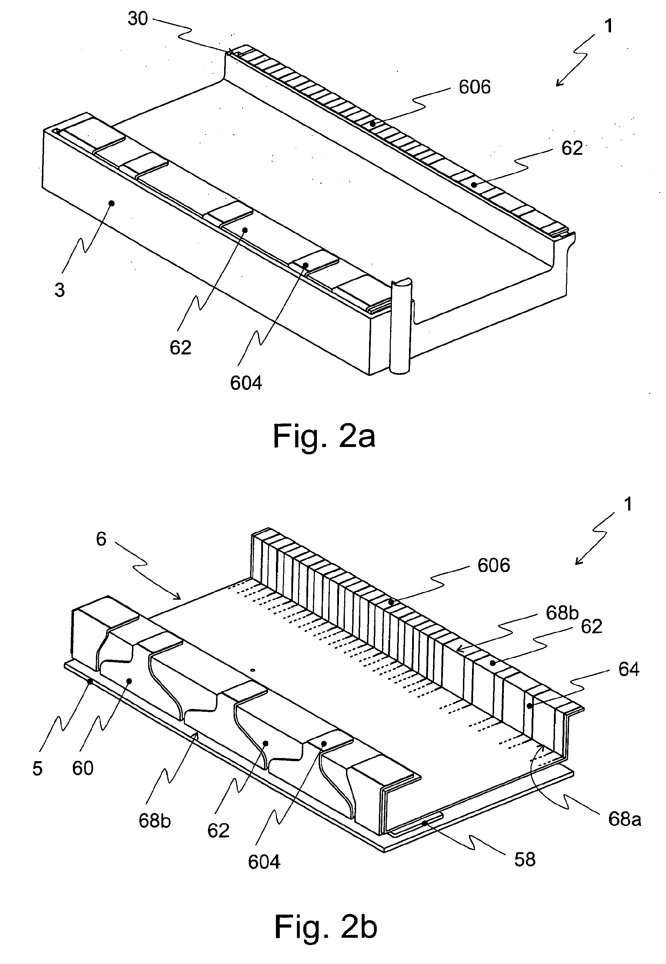

Fig. 2 zeigt eine erste Ausgestaltung eines erfindungsgemäßen Leistungshalbleitermoduls in dreidimensionaler Ansicht in Fig. 2a mit und in Fig. 2b ohne Gehäuse (3). Dargestellt ist hier ein Substrat (5) mit Leistungshalbleiterbauelementen (58). Diese Leistungshalbleiterbauelemente (58) sind schaltungsgerecht verbunden mittels einer Verbindungseinrichtung (6), welche aus einer ersten in sich strukturierten leitenden Folienschicht (60) besteht, welche Leiterbahnen ausbildet. Weiterhin besteht diese Verbindungseinrichtung aus einer isolierenden Folienschicht (62) und eine weiteren hierauf angeordneten ebenfalls in sich strukturierten, Leiterbahnen ausbildenden Folienschicht (64), wobei der jeweilige Verlauf der Leiterbahnen auf der zweiten Folienschicht (64) in Fig. 2b nur angedeutet ist.

Folienabschnitte dieser Verbindungseinrichtung (6) mit hierauf ausgebildeten Leiterbahnen reichen durch Führungsabschnitte (30) des Gehäuses (3) und sind auf der dem Substrat (5) abgewandten Seite des Gehäuses derart angeordnet, dass die Kontakteinrichtungen (604, 606) zur Last- sowie Steuerverbindung zu einer Leiterplatte eine Ebene bilden und parallele Flächennormalen aufweisen.

Hierzu weist der Folienabschnitt zu dritten Kontakteinrichtungen (604) eine erste und eine zweite Biegestelle (68b) mit gleicher Biegerichtung auf, wohingegen der Folienabschnitt zu vierten Kontakteinrichtungen (606) eine erste Biegestelle (68a) mit einer ersten Biegerichtung und im weiteren Verlauf eine zweite Biegestelle (68b) mit entgegen gesetzter zweiter Biegerichtung aufweist.

Die jeweiligen dritten Kontakteinrichtungen (604) sind erfindungsgemäß als Teilabschnitte von Leiterbahnen der ersten leitenden Schicht (60) und die vierten Kontakteinrichtungen (606) als Teilabschnitte von Leiterbahnen der zweiten leitenden Schicht (64) ausgebildet.

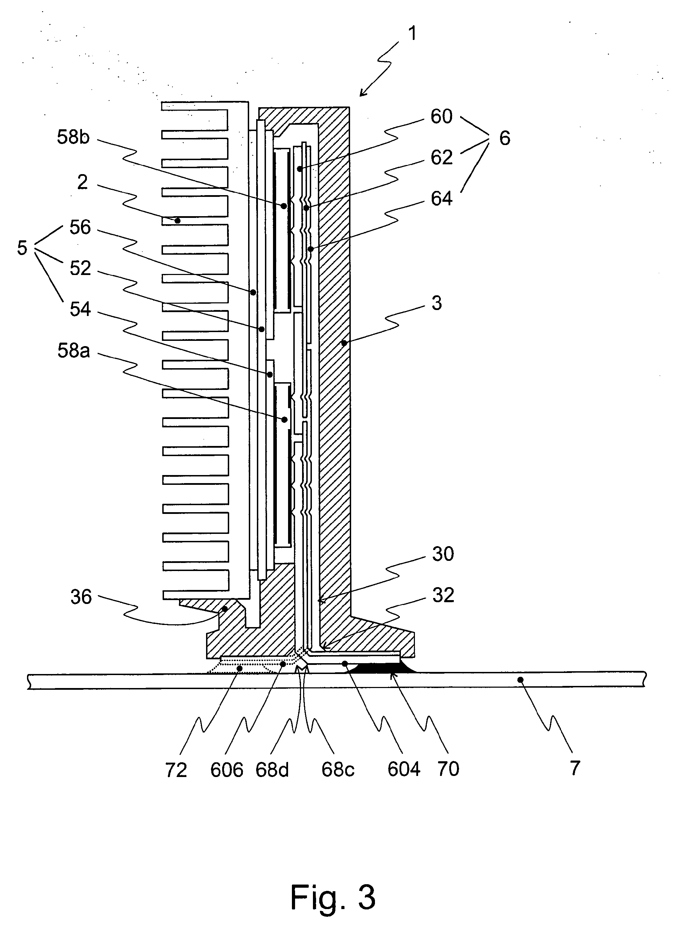

Fig. 3 zeigt eine zweite Ausgestaltung eines erfindungsgemäßen Leistungshalbleitermoduls im Schnitt in einer Anordnung mit einem Kühlkörper und einer. Leiterplatte. Die Ausgestaltung des Substrats mit angeordnetem Kühlkörper und Leistungshalbleiterbauelementen entspricht derjenigen gemäß Fig. 1, wobei sich der Kühlkörper hier auf einer speziellen Ausformung (36) des Gehäuses abstützt. Die Verbindungseinrichtung (6) besteht ebenfalls aus dem bereits beschriebenen Folienverbund einer ersten (60) und einer zweiten (64) leitenden und einer dazwischen angeordneten isolierenden Schicht (62). Die ersten und zweiten Kontakteinrichtungen (600, 602) zu Anschlussflächen (580, 582) von Leistungshalbleiterbauelementen (58 a/b) sind ebenso als Punktschweißverbindungen ausgebildet.

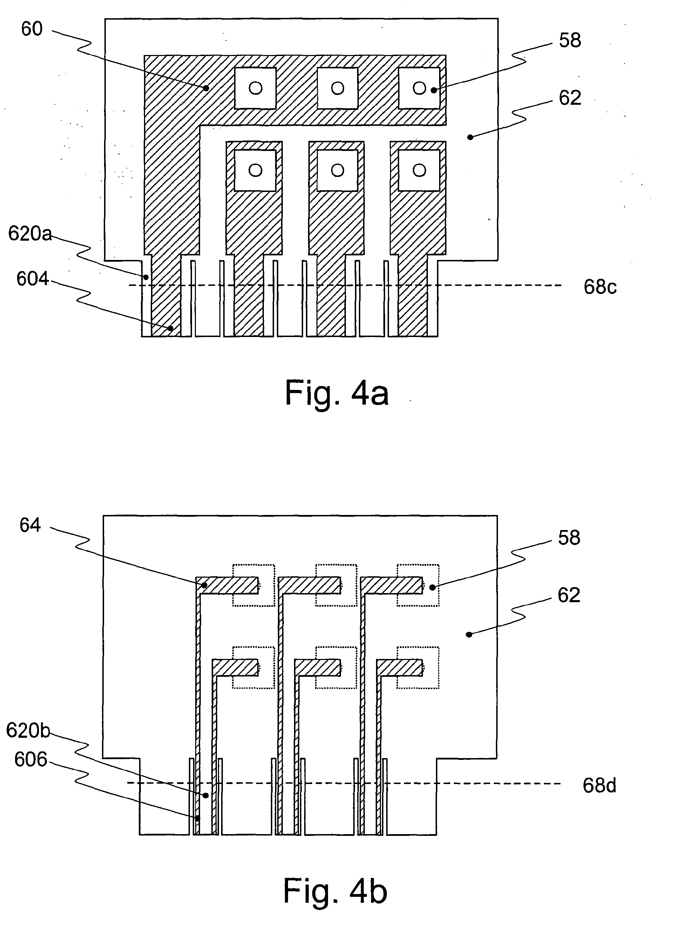

Das Gehäuse (3) umschließt das Substrat (5) und weist einen Führungsabschnitt (30) zur Anordnung eines Folienabschnitts zwischen den ersten und zweiten (600, 602) sowie dritten und vierten (604, 606) Kontakteinrichtungen zur Kontaktierung mit einer Leiterplatte (7) auf. Dieser Folienabschnitt zu dritten Kontakteinrichtungen (604) weist eine Biegestelle (68c) mit einer ersten Biegerichtung und der Folienabschnitt zu vierten Kontakteinrichtungen (606) eine zweite Biegestelle (68d) mit einer zweiten Biegerichtung auf. Hierdurch ergibt sich wiederum, dass die dritten (604) und vierten (606) Kontakteinrichtungen in einer Ebene hier allerdings senkrecht zur Substratebene angeordnet sind und wobei wiederum die Flächennormalen der Kontakteinrichtungen (604, 606) parallel angeordnet sind. Die detaillierte Ausgestaltung der Verbindungseinrichtung ist in Fig. 4 dargestellt.

Fig. 4 zeigt den Folienverbund, mit angedeuteten Leistungshalbleiterbauelementen, beispielhaft MOS-FETs, der Verbindungseinrichtung gemäß der zweiten Ausgestaltung nach Fig. 3 eines erfindungsgemäßen Leistungshalbleitermoduls. In Fig. 4a ist eine Lastverbindungsseite gebildet durch die erste leitende und die isolierende Schicht des Folienverbunds. Die isolierende Schicht (62) ist als eine Fläche mit einstückig mit der Fläche ausbildenden Ansätzen (620a) ausgebildet. Diese Ansätze (620a) bilden gemeinsam mit Leiterbahnen der ersten Folienschicht erste Folienabschnitte zur Anordnung in einem Führungsschacht des Leistungshalbleitermoduls. Hierbei bilden Teile der Leiterbahnen die dritten Kontakteinrichtung (604) gemäß Fig. 3 aus. Zur Ausbildung der senkrechten Anordnung dieser Kontakteinrichtungen (604) relativ zur Substratebene weist der Folienverbund eine erste Biegestelle (68c) auf.

In Fig. 4b ist eine Steuerverbindungsseite aus gleicher Blickrichtung wie in Fig. 2A dargestellt. Diese Steuerverbindungsseite wird gebildet durch die zweite leitende und die isolierende Schicht des Folienverbunds. Die isolierende Schicht (62) ist wiederum als eine Fläche mit einstückig mit der Fläche ausbildenden Ansätzen (620b) ausgebildet. Diese Ansätze (620b) bilden gemeinsam mit Leiterbahnen der zweiten Folienschicht zweite Folienabschnitte zur Anordnung in einem Führungsschacht des Leistungshalbleitermoduls. Hierbei bilden Teile der Leiterbahnen die vierten Kontakteinrichtung (606) gemäß Fig. 3 aus. Zur Ausbildung der senkrechten Anordnung dieser Kontakteinrichtungen (604) relativ zur Substratebene weist der Folienverbund eine zweite Biegestelle (68d) auf.

Durch die unterschiedliche Biegerichtung der ersten (68c) und zweiten Biegestelle (68d) werden die Kontakteinrichtung (604, 606) wie Fig. 3 dargestellt auf einer Ebene mit jeweils parallelen Flächennormalen ausgebildet.

## Patentansprüche

1. Leistungshalbleitermodul (1) mit einem Gehäuse (3), mindestens einem Substrat (5) mit Leiterbahnen (54) und hierauf schaltungsgerecht angeordneten Leistungshalbleiterbauelementen (58 a/b) und mit einer Verbindungseinrichtung (6),
wobei die Verbindungseinrichtung (6) aus einem Folienverbund aus einer ersten (60) und einer zweiten (64) leitenden jeweils in sich strukturierten und somit Leiterbahnen ausbildenden Schicht und einer dazwischen angeordneten isolierenden Schicht (62) besteht,
wobei die erste leitende Schicht (60) erste, als Punktschweißverbindungen ausgebildete Kontakteinrichtungen (600) zu Leistungsanschlussflächen (580) von Leistungshalbleiterbauelementen (58 a/b), zweite Kontakteinrichtungen (582) zu Steueranschlussflächen (582) von Leistungshalbleiterbauelementen (58a), ebenso wie dritte Kontakteinrichtungen (604) zur Lastverbindung (70) mit einer Leiterplatte (7) aufweist,
wobei die zweite leitende Schicht (64) schaltungsgerechte Verbindung (66) zur ersten leitenden Schicht (60) und vierte Kontakteinrichtungen (606) zur Steuerverbindung (72) mit einer Leiterplatte (7) aufweist,
wobei der Folienverbund Folienabschnitte zwischen den ersten und zweiten (600, 602) sowie den dritten und vierten (604, 606) Kontakteinrichtungen aufweist, die in Führungsabschnitten (30) des Gehäuses (30) angeordnet sind und wobei die dritten und vierten Kontakteinrichtungen (604, 606) parallele Flächennormalen aufweisen.

2. Leistungshalbleitermodul nach Anspruch 1,
wobei ein Folienabschnitt zu dritten Kontakteinrichtungen (604) eine erste (68b) und eine zweite Biegestelle (68b) mit gleicher Biegerichtung aufweist und ein Folienabschnitt zu vierten Kontakteinrichtungen (606) eine erste Biegestelle (68a) mit einer ersten Biegerichtung und im weiteren Verlauf eine zweite Biegestelle (68b) mit entgegen gesetzter zweiter Biegerichtung aufweist.

3. Leistungshalbleitermodul nach Anspruch 1,
wobei ein Folienabschnitt zu dritten Kontakteinrichtungen (604) eine Biegestelle (68c) mit einer ersten Biegerichtung und ein Folienabschnitt zu vierten Kontakteinrichtungen (606) eine zweite Biegestelle (68d) mit einer zweiten Biegerichtung aufweist.

4. Leistungshalbleitermodul nach Anspruch 3 oder 4,
wobei die Biegestellen (68 a/b/c/d) an zugeordneten Kanten (32) der Führungsabschnitte (30) des Gehäuses (3) angeordnet sind.

5. Leistungshalbleitermodul nach Anspruch 1,
wobei die dritten Kontakteinrichtungen (604) als Teilabschnitte von Leiterbahnen der ersten leitenden Schicht (60) und die vierten Kontakteinrichtungen (606) als Teilabschnitte von Leiterbahnen der zweiten leitenden Schicht (64) ausgebildet sind.

6. Leistungshalbleitermodul nach Anspruch 1,
wobei die dritten (604) und vierten (606) Kontakteinrichtungen das Gehäuse (3) in Richtung ihrer Flächennormalen überragen.

7. Leistungshalbleitermodul nach Anspruch 2,
wobei die dritten (604) und vierten (606) Kontakteinrichtungen in einer Ebene parallel zur Substratebene angeordnet sind.

8. Leistungshalbleitermodul nach Anspruch 3,
wobei die dritten (604) und vierten (606) Kontakteinrichtungen in einer Ebene senkrecht zur Substratebene angeordnet sind.

9. Leistungshalbleitermodul nach Anspruch 1,
wobei das Volumen zwischen dem Substrat (5) mit den Leistungshalbleiterbauelementen (58) und der ersten leitenden Schicht (60) mittels eines isolierenden Stoffes verfüllt ist.

10. Leistungshalbleitermodul nach Anspruch 9,
wobei der isolierende Stoff ein Silikongel oder eine Epoxidharz (584) ist.
